# EUROPEAN PATENT APPLICATION

(11) **EP 0 939 379 A1**
(43) Date of publication of application: **01.09.1999**
(21) Application number: 98932543.6
(22) Date of filing: 16.07.1998
(51) Int. Cl.: G06K 19/077, H01L 23/28

(54) **IC MODULE, IC CARD, SEALING RESIN FOR IC MODULE, AND METHOD FOR MANUFACTURING IC MODULE**

(30) Priority: 18.07.1997 JP 19386997; 05.08.1997 JP 21097697
(71) Applicant: DAI NIPPON PRINTING CO., LTD., Tokyo 162 (JP)
(72) Inventor: SHIMADA, Naoki-Dai Nippon Printing Co., Ltd., Tokyo 162-8001 (JP); OZAKI, Katsuyoshi-Dai Nippon Printing Co., Ltd., Tokyo 162-8001 (JP); GOGAMI, Masao-Dai Nippon Printing Co., Ltd., Tokyo 162-8001 (JP); FUKUSHIMA, Yoshikazu-Dai Nippon Printing Co., Ltd., Tokyo 162-8001 (JP)
(74) Representative: Rucker, Ernst, Dr. Dipl.-Chem.
(86) International application number: JP9803191
(87) International publication number: WO9904367

(57) **Abstract**

An IC card (10) comprises a base card (20), and an IC module (11) placed in a recess (21) formed in the base card (20). The IC module (11) comprises a substrate (12), a terminal member (13) formed on one of the surfaces of the substrate (12), and an IC chip (14) attached to the other surface of the substrate (12). The terminal member (13) is connected to the IC chip (14) by wires (15), and the IC chip (14) and the wires (15) are covered with a sealing resin covering (16). The sealing resin covering (16) is formed of a sealing resin containing a resin component and a solid component. The ratio in weight of the resin component to the solid component in a near-surface layer of the sealing resin covering (16) is in the range of 90:10 to 100:0.

## Description

The present invention relates to an IC module having a sealing resin covering, an IC card provided with the IC module, a sealing resin for sealing the IC chip, and an IC module fabricating method.

### BACKGROUND ART

The IC card provided with an IC module is protected by an advanced security and hence is expected to be applied to many fields. IC cards have become widely used in recent years as information recording mediums superseding magnetic cards.

An IC module employed in an IC card has an IC chip, and a sealing resin covering sealing the IC chip therein. Generally, a resin-sealing method forms a sealing package by transfer molding using tablets.

Transfer molding needs an expensive mold conforming to the size of the sealing resin covering, and hence it is difficult to reduce the cost of transfer molding when transfer molding is applied to IC modules of different sizes.

In view of such a background, an IC module having a sealing resin covering formed by printing a resin solution, and an IC card have been developed in recent years and have begun to be used practically.

Although the IC module having the sealing resin covering formed by applying a resin solution to the IC chip by the conventional method, and the IC card can be manufactured at a low manufacturing cost, the reliability of the same goes no higher than that of moldings formed by transfer molding. When forming the IC module and the IC card, the known method forms a high-strength frame on a substrate, and applies a resin solution to a region surrounded by the frame on the substrate. A sealing resin covering, particularly, a central part of the sealing resin covering, is formed by this method in a thickness smaller than that of the frame owing to the fluidity and the surface tension of the resin solution. When the IC module is mounted on a base card, a stress is induced locally in the thin central part of the sealing resin covering, and strength withstanding external force, such as point pressure, is reduced.

A known IC module is subjected to grinding after filling a space surrounded by the high-strength frame with a resin solution to form a sealing resin covering of a desired thickness. The reliability of such an IC module and an IC card provided with the same IC module is far higher than that of an IC module provided with a sealing resin covering formed by transfer molding and an IC card provided with this IC module, and that of an IC module provided with a sealing resin covering having a thin central part formed by using the frame and an IC card provided with this IC module. However, the IC module needs the high-strength frame and an additional surface grinding process, and hence the same cannot be manufactured at a low cost.

### DISCLOSURE OF THE INVENTION

The present invention has been made in view of the foregoing problems and it is an object of the present invention to provide a highly accurate IC module which can easily be fabricated at a low cost, an IC card, a sealing resin covering, and an IC module fabricating method.

According to a first aspect of the present invention, an IC module comprises a substrate, a terminal member, an IC chip, connecting members connecting the terminal member to the IC chip, and a sealing resin covering for covering the IC chip and the connecting members, in which the sealing resin covering is formed of a sealing resin containing a resin component and a solid component, the weight ratio of the resin component to the solid component in a near-surface layer of the sealing resin covering is in the range of 90:10 to 100:0, and a surface layer of the sealing resin covering consists of the resin component and the solid component occupying an area smaller than that occupied by the resin component.

According to the present invention, the IC chip and the connecting members are covered with the sealing resin covering, and the sealing resin covering is formed so that the weight ratio of the resin component to the solid component of in a near-surface layer of the sealing resin covering is in the range of 90:10 to 100:0, whereby the amount of the solid component which causes the surface of the sealing resin covering to crack can be reduced.

According to a second aspect of the present invention, an IC module comprises a substrate, an IC chip, and a sealing resin covering covering the IC chip, in which the IC chip is sealed in the sealing resin covering by hardening a sealing resin containing an epoxy resin, and having a viscosity in the range of 50 to 90 Pa·s at 25°C and a thixotropy index in the range of 1.2 to 1.6.

The IC module of the present invention is formed by covering an IC chip with a sealing resin having a viscosity not excessively low to allow the sealing resin to run out of a predetermined place and not excessively high to trap bubbles in the sealing resin and is capable of preventing the breakage of the IC chip.

Preferably, the sealing resin sealing the IC chip of the IC module of the present invention has a viscosity in the range of 50 to 70 Pa·s at 25°C and a thixotropy index in the range of 1.2 to 1.4. Such an IC sealing resin is less apt to run out of a predetermined place and less apt to trap bubbles therein.

Preferably, the sealing resin as hardened has an elastic modulus of 1400 kgf/mm² or above and a bending strength of 11 kgf/mm² or above. Such a sealing resin has a high strength sufficient to prevent the breakage of the IC chip.

According to a third aspect of the present invention, an IC card comprises an IC module comprising a substrate, a terminal member, an IC chip, connecting members connecting the terminal member to the IC chip, and a sealing resin covering covering the IC chip and the connecting members, the sealing resin covering being formed of a resin component and a solid component, the weight ratio of the resin component to the solid component in the near-surface layer of the sealing resin covering being in the range of 90:10 to 100:0, and the near-surface layer of the sealing resin covering consisting of the resin component and the solid component occupying an area smaller than that occupied by the resin component; and a base card provided with a recess for receiving the IC module therein.

According to a fourth aspect of the present invention, an IC card comprises an IC module comprising a substrate, an IC chip, and a sealing resin covering covering the IC chip; and a base card provided with a recess for receiving the IC module therein; in which the sealing resin covering is formed by hardening a sealing resin containing an epoxy resin, and having a viscosity in the range of 50 to 90 Pa·s at 25°C and a thixotropy index in the range of 1.2 to 1.6.

The IC card is formed by placing the IC module formed by covering the IC chip with the sealing resin having a viscosity not excessively low to allow the sealing resin to run out of a predetermined place and not excessively high to trap bubbles in the sealing resin, and is capable of preventing the breakage of the IC chip.

In the IC card according to the present invention, it is preferable that the sealing resin sealing the IC chip of the IC module has a viscosity in the range of 50 to 70 Pa·s at 25°C and a thixotropy index in the range of 1.2 to 1.4. Such an IC sealing resin is less apt to run out of a predetermined place and less apt to trap bubbles therein.

In the IC card according to the present invention, it is preferable that the sealing resin as hardened has an elastic modulus of 1400 kgf/mm² or above and a bending strength of 11 kgf/mm² or above. Such a sealing resin has a high strength sufficient to prevent the breakage of the IC chip even if an external force is applied directly to the IC module.

According to a fifth aspect of the present invention, an IC module fabricating method comprises the steps of preparing a substrate; forming a terminal member; mounting an IC chip on the substrate; connecting the terminal member to the IC chip by connecting members; covering the IC chip and the connecting members with a resin solution containing a resin component and a solid component; and forming a sealing resin covering by hardening the resin solution so that the weight ratio of the resin component to the solid component in the near-surface layer of the sealing resin covering is in the range of 90:10 to 100:0, and a surface layer of the sealing resin covering consists of the resin component and the solid component occupying an area smaller than that occupied by the resin component.

According to a sixth aspect of the present invention, an IC module fabricating method comprises the steps of preparing a substrate; forming a terminal member; mounting an IC chip on the substrate; electrically connecting the terminal member to the IC chip; covering the IC chip with a sealing resin containing an epoxy resin and having a viscosity in the range of 50 to 90 Pa·s at 25°C and a thixotropy index in the range of 1.2 to 1.6 before hardening; and hardening the sealing resin.

The IC module fabricating method according to the present invention forms the terminal member on the substrate, mounts the IC chip on the substrate, connects the terminals electrically to the IC chip by bonding wires or the like, and seals the IC chip with the sealing resin containing an epoxy resin and having a viscosity in the range of 50 to 90 Pa·s at 25°C and a thixotropy index in the range of 1.2 to 1.6 before hardening; and hardening the sealing resin.

In the foregoing IC module fabricating method according to the present invention, it is preferable that the sealing resin has a viscosity in the range of 50 to 70 Pa·s at 25°C and a thixotropy index in the range of 1.2 to 1.4. Such an IC sealing resin is less apt to run out of a predetermined place and less apt to trap bubbles therein.

In the foregoing IC module fabricating method according to the present invention, it is preferable that the sealing resin as hardened has an elastic modulus of 1400 kgf/mm² or above and a bending strength of 11 kgf/mm² or above. Such a sealing resin has a high strength sufficient to prevent the breakage of the IC chip even if an external force is applied directly to the IC module.

According to a seventh aspect of the present invention, a sealing resin for sealing an IC chip mounted on a substrate to form an IC module has a viscosity in the range of 50 to 90 Pa·s at 25°C and a thixotropy index in the range of 1.2 to 1.6 before hardening.

Thixotropy index is the ratio of a viscosity of a substance stirred with a stirrer rotating at a specified rotating speed to a viscosity of the same stirred with the stirrer rotating at a rotating speed ten times the specified rotating speed. For example, thixotropy index is defined by the ratio of a viscosity when a substance is stirred at 5 rpm to a viscosity when the same substance is stirred at 50 rpm. Thixotropy index for water is 1 (one). A sealing resin having a viscosity below 50 Pa·s or a thixotropy index below 1.2 is excessively fluidic and spreadable, runs out of a predetermined place. A sealing resin having a viscosity above 90 Pa·s or a thixotropy index above 1.6 is excessively nonfluidic and unspreadable and is apt to trap bubbles therein.

This IC module sealing resin has a viscosity not excessively low to allow the IC module sealing resin to run out of a predetermined place and not excessively high to trap bubbles in the IC module sealing resin, and is capable of reducing the possibility of bringing about the breakage of the IC chip.

Preferably, the IC module sealing resin has a viscosity in the range of 50 to 70 Pa·s at 25°C and a thixotropy index in the range of 1.2 to 1.4. Such an IC sealing resin is less apt to run out of a predetermined place and less apt to trap bubbles therein.

Preferably, the IC module sealing resin has an elastic modulus of 1400 kgf/mm² or above and a bending strength of 11 kgf/mm² or above. Such an IC module sealing resin has a high strength sufficient to prevent the breakage of the IC chip even if an external force is applied directly to the IC module.

### BRIEF DESCRIPTION OF THE DRAWINGS

Fig. 1 is a sectional side elevation of an IC module in a first embodiment according to the present invention;
Fig. 2 is a sectional side elevation of an IC card provided with the IC module in the first embodiment;
Fig. 3 is a graph showing the point pressure withstand strength of IC cards;
Fig. 4 is a view of an IC card embodying the present invention;
Fig. 5 is a view of an IC card embodying the present invention;
Fig. 6 is a view of an IC card embodying the present invention;
Fig. 7 is a view of a combination of an IC chip and a base card with a space formed therebetween filled up with an adhesive;
Figs. 8(a) to 8(c) are views of IC cards employing substrates provided with openings of special shapes, respectively;
Figs. 9(a) to 9(c) are views of IC cards employing substrates provided with openings of special shapes, respectively;
Fig. 10 is a view of assistance in explaining the relation between a sealing resin covering and a frame;
Fig. 11 is a sectional view of an IC module in a second embodiment according to the present invention;
Fig. 12 is a sectional view of an IC card provided with the IC module in the second embodiment; and
Fig. 13 is a graph showing measured point pressure withstand strength of IC cards according to the present invention.

### BEST MODE FOR CARRYING OUT THE INVENTION

### First Embodiment

Preferred embodiments of the present invention will be described hereinafter with reference to the accompanying drawings.

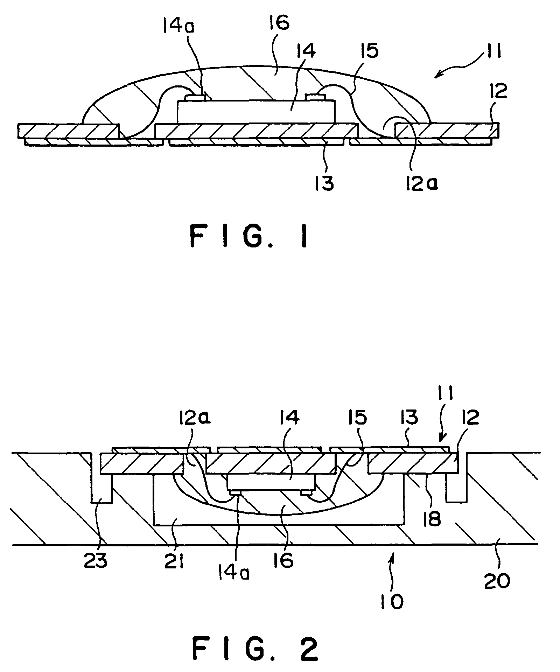

Figs. 1 to 3 show preferred embodiments of the present invention. Referring to Figs. 1 to 3, an IC module 11 according to the present invention comprises a substrate 12, terminal member 13 formed on one surface of the substrate 12, and an IC chip 14 mounted on the other surface of the substrate 12. The IC chip 14 has terminals 14a connected to the terminals of the terminal member 13 by wires 15 extended through openings 12a formed in the substrate 12. The IC chip 14 and the wires are covered with a sealing resin covering 16. The sealing resin covering 16 has an outward convex shape and a generally semielliptic section (Figs. 1 and 2).

The IC module 11 is received in a recess 21 formed in a base card 20 to construct an IC card 10 comprising the IC module 11 and the base card 20 (Fig. 2). The IC module 11 is bonded to a support surface 18 formed in the base card 20 by an adhesive. An outer groove 23 is formed in the base card 20 so as to surround the recess 21 to enable the base card 20 to yield under an external pressure exerted thereon to absorb stress.

The sealing resin covering 16 is formed of a material containing a resin component and a solid component. It is preferable that the resin component is heat-resistant and has a high mechanical strength. Generally, a resin containing, as a principal component a thermosetting epoxy resin is used prevalently for forming the sealing resin covering 16. Such an epoxy resin is a bisphenol A epoxy resin, a bisphenol F epoxy resin, a novolac epoxy resin, or a cycloaliphatic epoxy resin. A hardening agent, such as one of acid anhydrides including fatty acid anhydrides, aromatic acid anhydrides and chlorinated acid anhydrides, or one of modified amines including aliphatic polyamines, alicyclic polyamines, aromatic polyamines and polyamide-polyamines, is added to the epoxy resin. The solid component is added to the resin component to improve the strength of the resin component and relaxing stress induced in the resin component during hardening. The solid component is an inorganic filler such as silica, alumina, quartz, aluminum hydroxide, calcium carbonate, titanium oxide or talc. The resin component may be of a sea island structure prepared by dispersing an organic rubber, such as silicone, urethane, polybutadiene or an acrylic elastomer, in a matrix, such as an epoxy resin. Fine particles of colloidal silica having a large area per unit weight may be added as a filler to the resin component to provide the resin component with a thixotropic property.

It is particularly preferable that the sealing resin forming the sealing resin covering 16 contains, as a principal component, the epoxy resin, and 70 to 90% by weight silica as a filler (solid component) in view of securing a sufficient physical strength and reducing stress. Silica may be in spherical particles, flakes or tetrapod particles called acicular crystals. Silica of a desired shape may be used. Preferably, the particle size of silica is in the range of about 10 to about 30 µm.

The substrate 12 of the IC module 11 is a flexible glass-epoxy sheet, a polyimide sheet, a polyester sheet, a paper-base phenolic laminated sheet or a BT resin sheet. It is preferable, in view of flexibility and covering wires with the sealing resin, the sum of the respective thicknesses of the substrate 12 and the terminal member 13 is 130 µm or below. The terminal members 13 are formed by subjecting a copper foil laminated to the substrate of the IC module to photolithographic etching. The copper foil may be either a rolled copper foil or an electrolytic copper foil. A Ni film is formed on the copper foil by Ni-plating, and a hard or soft gold film is formed on the Ni film by gold-plating to complete the terminal member. A silver film may be employed instead of the gold film.

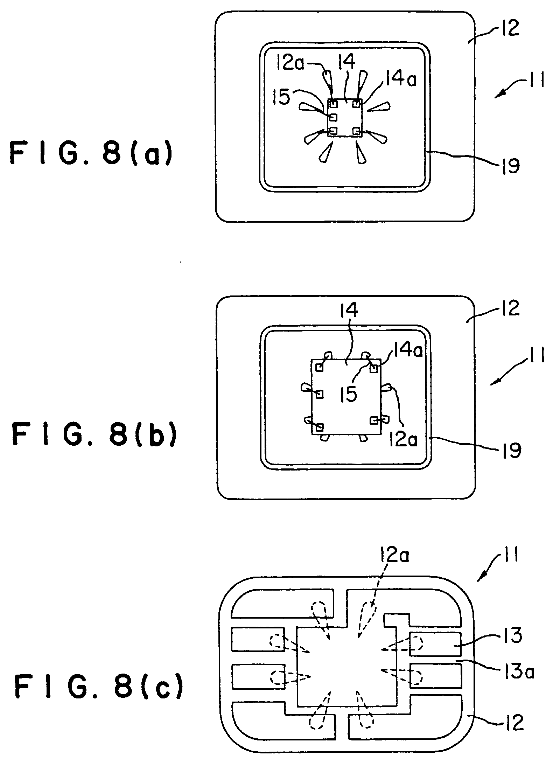

A surface of the substrate 12 to be coated with the sealing resin may be matte or smooth. The surface of the substrate 12 may be provided with a frame 19 (Figs. 8(a) and 8(b)) for retaining a resin solution on the surface of the substrate 12. Silk-screen printing is a desirable, simple method of forming the frame 19. The frame is formed of the same material as the sealing resin covering 16, such as an epoxy resin, a polyester resin or a resin for forming a solder resist. Although a high frame is excellent in retaining the resin solution, the high frame is brittle. Therefore a preferable height of the frame is in the range of about 1/5 to about 1/10 of the width of the frame. The width of the frame may optionally be determined, taking into consideration the size of the IC chip or the bonding area in which the base card is bonded to the substrate.

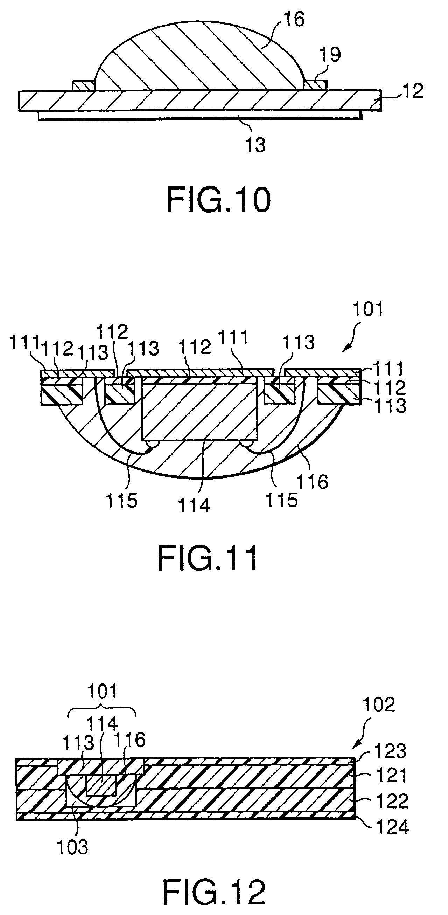

The relation between the frame 19 and the sealing resin covering 16 will be explained with reference to Fig. 10, in which a structure sealed in the sealing resin part 16 is omitted for convenience. Suppose that the sum of the respective thicknesses of the substrate 12 and the terminals of the terminal member 13 is 110 µm. Then, it is preferable that the height of the sealing resin covering 16 is in the range of 470 to 510 µm in view of properly covering the wires, ensuring strength that withstands external pressure and safely forming a recess in the base card. Preferably, the height of the frame 19 is in the range of 5 to 15 µm. The frame 19 is unable to retain the resin solution if the height thereof is less than 5 µm. The width of the frame is excessively great, the bonding area in which the substrate is bonded to the base card is excessively small and bond strength holding together the substrate and the base card is insufficient if the height of the frame 19 is greater than 15 µm.

The ratio of the height of the frame to the height of the sealing resin covering is in the range of 5/510 to 15/470, i.e., 0.98% to 3.19%.

The viscosity parameter of the resin component of the resin solution consisting of the resin component and the solid component may properly be determined instead of finishing the surface of the substrate 12 in a matte surface or forming the frame on the substrate to prevent the resin solution from flowing. In view of forming the sealing resin covering 16 in appropriate shape and avoiding the formation of voids in the sealing resin covering 16, a preferable viscosity of the resin component is in the range of 50 to 70 Pa·s at 25°C.

When the sealing resin covering 16 is formed by using a resin solution containing an inorganic filler or rubber as a solid component, and a high-strength resin, and thickness of the sealing resin covering 16 is adjusted by grinding, it is possible that an inhomogeneous layer (noncompatible layer) in which the inorganic filler or the rubber is dispersed in the resin component is exposed on the surface of the sealing resin covering 16. If external pressure is applied to this sealing resin covering 16, stress induced in the sealing resin covering 16 propagates through the boundaries between the resin component and the filler (or the rubber), i.e., the solid component, or through the filler (or the rubber) and cracks are apt to develop between the resin component and the filler (or the rubber). It is considered that such cracks in the sealing resin covering 16 reduce the effect of the sealing resin covering 16 in protecting the IC chip 14, and the wires 15 electrically connecting the terminals of the terminal member 13 to the IC chip 14.

When the thickness of the IC module is adjusted by grinding, a method uses a homogeneous sealing resin of only a flexible resin component (a material not containing any filler (or rubber) for improving brittleness or stress) and another method uses a high-strength material for reinforcing a peripheral portion of the sealing resin covering by a flame of a reinforced plastic reinforced by a ceramic, carbon fibers or a liquid crystalline polymer or a metal. The sealing resin covering formed by the former method has a strength insufficient to withstand external pressure, such as point pressure, that might be exerted thereon, has a low effect on protecting the IC chip 14 and hence cannot be used for purposes in which reliability is essential. Although the protective effect of the frame of the sealing resin covering formed by the latter method is effective and reliable, a process of forming the frame is complicated and the frame increases the cost.

The present invention uses the resin solution containing the resin component and the solid component, such as a filler, for forming the sealing resin covering 16, and adjusts the composition of a near-surface layer of the sealing resin covering 16 by the agency of gravity so that the weight ratio of the resin component to the solid component in the near-surface layer is in the range of 90:10 to 100:0. Thus, the filler content of the near-surface layer of the sealing resin covering 16 is reduced to reduce the amount of the solid component, such as a filler, which causes cracks. Therefore, cracking of the sealing resin covering 16 by external pressure exerted on the sealing resin covering 16 can be prevented. The near-surface layer of the sealing resin covering 16 is a layer lying, for example, a distance corresponding to the particle size (about 20 µm) of the filler inside the surface of the sealing resin covering 16. When the ratio in weight of the resin component to the solid component is in the range of 90:10 to 100:0, a surface layer of the sealing resin covering consists of the resin component and the solid component, and the area occupied by the solid component is smaller than that of portions of the same occupied by the resin component. If the solid component content of the near-surface layer of the sealing resin covering 16 is greater than that corresponding to the upper limit of the range of 90:10 to 100:0 of the ratio in weight of the resin component to the solid component, the area occupied by the solid component in the surface of the sealing resin covering may be increased. Consequently, when external pressure is applied to the sealing resin covering 16, the external pressure propagates through boundaries between the resin component and the solid component to cause cracks in the sealing resin covering 16.

When the sealing resin covering 16 has an elastic modulus of 1400 kgf/mm² or above and a bending strength of 11 kgf/mm² or above (JIS K6911), the sealing resin covering 16 is highly effective in protecting the IC chip. If the sealing resin covering 16 has a strength below 11 kgf/mm², the sealing resin covering 16 is able to secure protective effect against external pressure, such as point pressure, however, the strength is insufficient. When the sealing resin covering 16 has a strength above 11 kgf/mm², particularly, when the surface of the sealing resin covering 16 is coated with a resin, the sealing resin covering 16 has a strength sufficient to withstand external pressure.

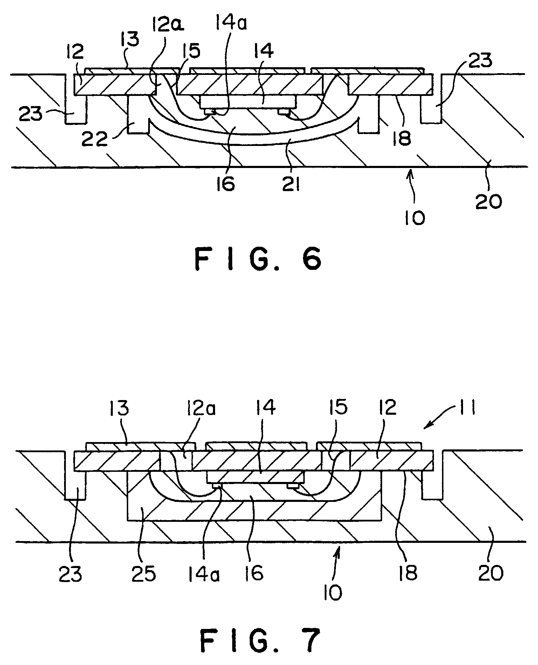

It is preferable that at least a central part of the sealing resin covering 16 of the IC module 11 is in direct contact with the base card 20. A space between at least a central part of the sealing resin covering 16 and the base card 20 may be filled up with a packing material 25 (Fig. 7). Preferably, the packing material 25 filling up the space between at least the central part of the sealing resin covering 16 and the base card 20 is an adhesive capable of bonding together the sealing resin covering 16 and the base card 20.

The adhesive 25 bonding together the central part of the sealing resin covering 16 and the base card 20 is a cyanoacrylate adhesive.

When the sealing resin covering 16 of the IC module 11 bonded to the base card 20 by the packing material 25 as shown in Fig. 7, the strength resisting external force, particularly, point pressure, exerted on the IC module 11 is enhanced. Such an effect can be explained from the propagation of pressure in an IC module 11 employing a flexible tape substrate 12 when point pressure is applied to the same IC module 11. Suppose that the IC card 10 provided with the IC module is placed on a metal plate with the terminals of the terminal member 13 of the IC module 11 facing up, and a point pressure is applied to a central terminal 13 with a metal ball. Then, only a part of the sealing resin covering 16 corresponding to the central terminal 13 comes into contact with the base card 20 if a gap is formed between the sealing resin covering 16 of the IC module and the card base 20 because the substrate 12 is flexible. Consequently, stress is concentrated excessively only on a part of the sealing resin covering 16 and the sealing resin covering 16 is apt to crack.

When the sealing resin covering 16 of the IC module 11 is connected to the base card 20 by the filling material 25, external force applied to the IC module is distributed in the contact area. Therefore, the sealing resin covering 16 cannot easily be cracked even if the external force is point pressure. If the IC module 11 is sunken greatly by point pressure and a gap is formed between the IC module 11 and the base card 20, stress is concentrated between the sealing resin covering 16 and the base card 20 and the surface layer of the sealing resin covering 16 tends to come off. The reliability of such a structure is inferior.

A circuit formed on the IC chip 14, particularly, a central part of the IC chip 14, is susceptible to external pressure, such as point pressure. Pressure distributing effect is available when at least a central part of the sealing resin covering 16 of the IC module 11 is connected to the base card 20. The reduction of the strength of the sealing resin part 16 due to pressure propagation or the sinking of the IC module 11 is significant when the substrate 12 of the IC module 11 is a flexible tape, and the stress is relatively high even if the substrate 12 has a high strength. Therefore, the sealing resin covering 16 is connected to the base card 20 to distribute pressure properly.

The IC module 11 can stably be placed in the recess 21 of the base card 20 when the respective design accuracies of the thickness of the IC module 11 and the depth of the recess 21 of the base card 20 are determined so that a gap is formed between the sealing resin covering 16 and the base card 20. The gap between the sealing resin covering 16 and the base card 20 is filled up with the packing material 25 to secure pressure distributing effect.

The packing material 25 may be any one of plastics, metals, pigments and the like, provided that the packing material 25 is able to fill up the gap between the sealing resin covering 16 and the base card 20. Preferably, the packing material 25 is sufficiently fluidic to fill up the gap uniformly, and has a high rigidity when hardened, a Shore hardness D of 50 or above and a high strength higher than that of the sealing resin covering 16.

It is particularly preferable, in view of bonding together the sealing resin covering 16 and the base card 20 by a high bonding strength, to use an adhesive capable of bonding together the sealing resin covering 16 and the base card 20 as the packing material 25. Such an adhesive is determined selectively, taking into consideration of the materials forming the sealing resin covering 16 and the base card 20. The packing material 25 may be any suitable one of acrylic adhesives, urethane adhesives, silicone adhesives, epoxy adhesives, rubber adhesives, ultraviolet curable adhesives, emulsion adhesives and the like. In view of rigidity after hardening, cyanoacrylate adhesive is a desirable material. Cyanoacrylate adhesives are able to adhere firmly to the sealing resin covering 16 and the base card 20 and are capable of preventing the IC module 11 from separating from the base card 20. As the packing material 25, a slow-setting adhesive is more preferable than a quick-setting adhesive in respect of facility in handling.

As mentioned above, the terminals of the terminal member 13 arranged on the substrate 12 are connected electrically to the IC chip 14 by the wires 15. As shown in Figs. 8(a) to 8(c), the openings 12a of the substrate 12 corresponding to the shapes of the terminals of the terminal member 13 to which terminals 14a formed on the IC chip 14 are connected by the wires 15 as viewed from the side of the IC chip 14 are formed so as to extend radially. Each of the openings 12a has a rectangular, elliptic or sectorial shape. The adjacent terminals of the terminal member 13 are separated from each other by isolating grooves 13a.

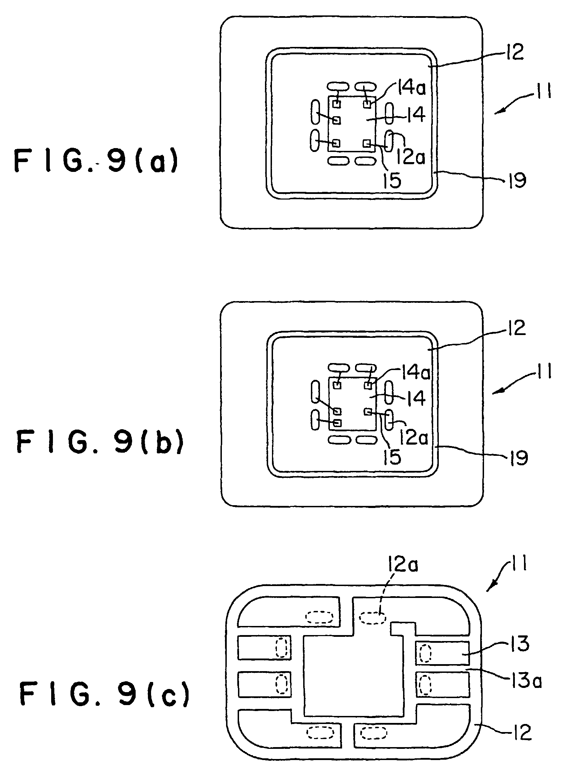

As shown in Figs. 9(a) to 9(c), the openings 12a of the substrate 12 having shapes corresponding to the shapes of the terminals of the terminal member 13 as viewed from the side of the IC chip 14 may be arranged in parallel to the long and the short side of the substrate 12, and the shapes may be rectangular or elliptic. Isolating grooves 13a are formed between the adjacent terminals of the terminal member 13.

As mentioned above, when the sealing resin covering 16 is formed by printing the resin solution on the IC chip 14 by screen printing or by applying the resin solution to the IC chip 14 by a dispenser, a central part of the sealing resin covering 16 is formed in a thickness greater than that of a peripheral part of the same because the resin solution is fluidic (the resin solution is required to be fluidic to some extent and to have a relatively low viscosity because bubbles formed in the resin solution when the resin solution is applied to the IC chip 14 cannot be removed if the resin solution has a high viscosity), and the sealing resin covering 16 is formed in uneven thickness. When the terminals of the terminal member 13 are connected to the IC chip 14 by wire bonding, problem arises in covering the wires 15. As shown in Figs. 8(a), 8(b), 9(a) and 9(b), the height of loops of the wires 15 is dependent on the size and thickness of the IC chip, the positional relation between the terminals 14a of the IC chip 14 and the terminals of the terminal member 13 of the substrate 12, and the shape of the loops of the wires 15. However, different IC chips for different uses have different sizes and thicknesses, respectively. Therefore, different substrates 12 must be fabricated respectively for different IC chips 14 to extend the wires 15 in loops of a low height so that the wires 15 can satisfactorily be covered.

According to the present invention, the plurality of openings 12a are formed in the substrate 12 in rectangular, elliptic or sectorial shapes radially extending about the center axis of the IC module 11 as shown in Figs. 8(a), 8(b) and 9(a). Therefore, the wires 15 can be extended in optimum low loops even if the same substrate 12 is used in combination with different IC chips 14 differing from each other in thickness and size or in the arrangement of the terminals 14a.

When the substrate 12 is provided with the plurality of openings 12a formed in a radial arrangement, the terminals 14a of the IC chip 14 can properly be connected to the terminals of the terminal member 13 by the wires 15 extended through the openings 12a even if the IC chip 14 is small (Fig. 8(a)), and the terminals 14a of the IC chip 14 can properly be connected to the terminals of the terminal member 13 by the wires 15 extended through the openings 12a even if the IC chip 14 is large (Fig. 8(b)).

Since the length and the looped shape of the wires 15 can optionally be determined for IC chips 14 of different sizes, the IC module 11 having wires 15 not exposed outside the sealing resin covering 16 can stably be fabricated. Particularly, when the openings 12a of the substrate 12 are formed in a sectorial shape, the same substrate 12 can be used in combination with different IC chips 14 differing from each other in the arrangement of the terminals 14a.

When the openings 12a of the substrate 12 are formed in a rectangular or elliptic shape and are arranged with their length extended in parallel to the long and the short side of the substrate 12, respectively, the wires 15 can properly be bonded to the terminals 14a of different IC chips 14 differing from each other in the arrangement of the terminals 14a as shown in Figs. 9(a) and 9(b).

All the wires 15 may be extended in a direction inclined at an angle of 20° to a printing direction to reduce load that may be exerted by the resin solution on the wires 15 when coating the plurality of wires 15 connecting the terminals 14a of the IC chip 14 to the terminals of the terminal member 13 with the sealing resin by screen printing.

Methods of fabricating the IC module and the IC card will be described hereinafter.

Referring to Figs. 1 and 2, the flexible substrate 12 of a glass-epoxy sheet, a polyimide sheet, a polyester sheet, a paper-base phenolic laminated sheet or a BT resin sheet for forming the IC module is prepared. The terminal member 13 is formed on one of the surfaces of the substrate 12, and the IC chip 14 is mounted on the other surface of the substrate 12. The terminals of the terminal member 13 are connected to the IC chip 14 by the wires 15.

The IC chip 14 is set on a printing table, now shown, with the substrate 12 facing upwardly, and the resin solution containing the resin component and the solid component is printed on the substrate in a tablet so as to cover the IC chip 14 and the wires 15. The tablet of the resin solution has a high central part and a low peripheral part owing to the viscosity of the resin solution, and the tablet has a semielliptic section.

The tablet of the resin solution is hardened while the substrate 12 is held in the same position. Particles of the solid component contained in the tablet of the resin solution are caused to move downward by gravity while the tablet of the resin solution is hardening. Consequently, the solid component content of a surface layer of the tablet decreases, and the sealing resin covering 16 having a surface layer containing the resin component and the solid component in a weight ratio of the resin component to the solid component in the range of 90:10 to 100:0 is formed.

Usually, the five terminals 14a of the IC chip 14 are used when the IC chip 14 is used for forming the IC card 10. It is preferable that the terminals 14a are formed so that the plurality wires 15 electrically connecting the terminals of the terminal member 13 of the substrate 12 to the terminals 14a of the IC chip 14 extend substantially in the same direction. When applying the resin solution to the substrate 12 by screen printing, the resin solution is spread in the direction in which the wires 15 are extended to prevent trapping bubbles in the resin solution and breaking the wires 15.

The resin solution must have a certain viscosity to enable the sealing resin covering 16 to maintain its shape and to relax stress. Therefore, the resin solution is spread in the direction in which the wires 15 are extended by screen printing to reduce load on the wires 15. When the resin solution is spread in a direction perpendicular to the wires 15, load on the wires 15 increases to a maximum and the wires 15 may possibly be broken.

When the resin solution is spread in the direction in which the wires 15 are extended, load on the wires 15 decreases to a minimum and the wires 15 may rarely be broken.

It is possible that the wires 15 are disconnected from the terminals 14a of the IC chip 14 and the terminals of the terminal member 13 of the substrate 12 when the wires 15 are stressed. When the plurality wires 15 are extended in the same direction, the resin solution can be spread in a direction parallel to the wires 15 and the load exerted on the wires 15 by screen printing can be reduced to a minimum, so that the breakage of the wires 15 can be prevented.

When the wires 15 of the same length are extended in parallel to the long or the short sides of the IC chip 14, the IC chip 14 and the wires 15 are arranged in a well-balanced structure, local concentration of external pressure hardly occurs, and strength is stabilized (evenness of strength is improved).

When the wires 15 of the same length are extended in parallel to the long or the short sides of the IC chip 14 at the same height, differences in thickness between parts of the sealing resin covering 16 can be small, and the sealing resin covering 16 can be formed in a small thickness. The same effect can be made by a sealing resin covering formed by using a dispenser as well as the sealing resin covering 16 formed by screen printing.

The IC module 11 is thus fabricated by the foregoing processes. The IC module 11 is placed in the recess 21 of the base card 20, and is bonded to the support surface of the base card 20 by an adhesive to complete the IC card 10.

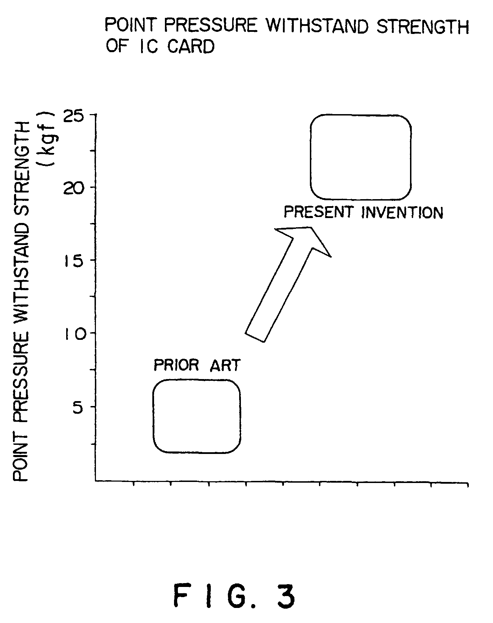

Functions and effects of the IC card 10 and the IC module 11 of the present invention will be described with reference to Fig. 3. The strength of the IC module to withstand external pressure, such as point pressure, is far higher than that of the conventional IC module.

Such a high strength can be ensured because the solid component content of the surface layer of the sealing resin covering 16 is small and hence the sealing resin covering 16 hardly cracks. Since the base card 20 is provided with the outer groove 23, stress is concentrated on the portion of the base card 20 provided with the outer groove 23 when the base card 20 is bent, so that stress induced in the sealing resin covering 16 of the IC module 11 can be reduced. Therefore, the IC card 20 has a high physical strength to withstand point pressure and the like, and a high bending strength.

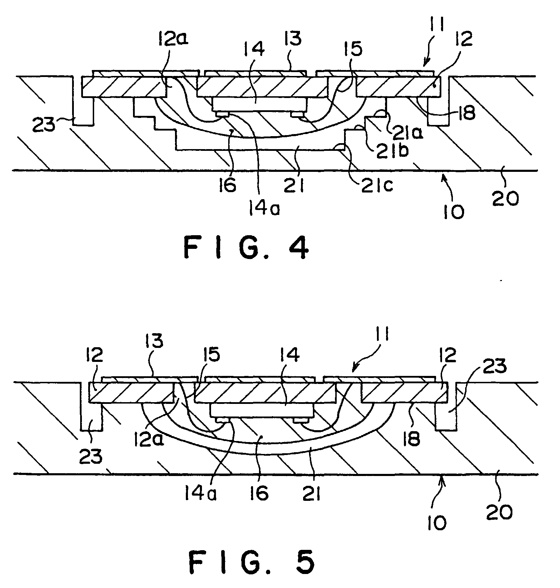

Other embodiments of the present invention will be described hereinafter with reference to Figs. 4 to 6.

IC cards 10 shown in Figs. 4 to 6 differ from the IC card 10 in the first embodiment shown in Figs. 1 to 3 only in the construction of their base cards 20 and are the same in other respects as the first embodiment shown in Figs. 1 to 3. In Figs. 4 to 6, parts like or corresponding to those of the first embodiment shown in Figs. 1 to 3 are designated by the same reference characters and the description thereof will be omitted.

Referring to Fig. 4, a sealing resin covering 16 has a semielliptic section, and a base card 20 is provided with a recess 21 of a sectional shape substantially corresponding to that of the sealing resin covering 16. The recess 21 of the base card 20 has depth increasing in steps and the surface of the recess 21 has steps 21a, 21b and 21c. Thus the sectional shape of the recess 21 corresponds substantially to that of the sealing resin covering 16.

The difference in depth between the peripheral step 21a and the central step 21c is at least 100 µm.

The sealing resin covering 16 formed by spreading the resin solution has a central part of a thickness greater than that of a peripheral part. Therefore, if the recess 21 of the card base 20 is formed in a uniform depth, the gap between the sealing resin covering 16 and the base card 20 increases from the central part toward the peripheral part of the sealing resin covering 16, and strength to withstand external pressure, such as point pressure, is reduced. The gap between the sealing resin covering 16 and the base card 20 can be narrowed when the plurality of steps 21a, 21b and 21c are formed so that the difference in depth between the steps 21a and 21c is at least 100 µm to secure a high strength to withstand load, such as diagonal external force. Although it is preferable to form the sealing resin covering 16 and the recess 21 of the card base 20 in the same shape, it is impossible to form the sealing resin covering 16 by a method using printing or a method using a dispenser so that the shape of the sealing resin covering 16 coincides perfectly with that of the recess 21. Therefore, some clearances must be formed between portions of the sealing resin covering 16 and the corresponding portions of the recess 21.

As shown in Figs. 5 and 6, a sealing resin covering 16 may be formed in a shape having a semielliptic section, and a card base 20 may be provided with a recess 21 of a shape having an elliptic section similar to that of the sealing resin covering 16. A peripheral groove 22 maybe formed around the recess 21 as shown in Fig. 6.

Bending stress induced in the sealing resin covering 16 can be relaxed to some extent by the outer groove 23 formed in the base card 20. Although the stress relaxing function of the outer groove 23 is effective when the base card 20 is bent so that the surface of the IC module 11 provided with the terminals of the terminal member 13 is curved in an outward convex shape (convex bending), the same is not very effective when the base card 20 is bent so that the surface of the IC module 11 provided with the terminals of the terminal member 13 is curved in an outward concave shape (concave bending). Since the outer groove 23 is on the outer side of the support surface 18 of the base card 20 supporting the IC module 11, force is liable to act directly on the IC module 11 when the base card 20 is subjected to concave bending.

Although it is desirable to form a stress relaxing groove similar to the outer groove in the surface opposite to the surface on which the IC module 11 is attached to achieve stress relaxation in concave bending as well as in convex bending, such a stress relaxing groove is not desirable because the stress relaxing groove will spoil the appearance of the IC card. Therefore, a stress relaxing groove 22 is formed in the base card 20 so as to surround the recess 21 to prevent the breakage of the IC chip 14 or the wires 15 covered by a central part of the sealing resin covering 16 by intentionally making a peripheral part of the sealing resin covering 16 corresponding to the stress relaxing groove 22. The depth of the stress relaxing groove 22 to make the stress relaxing groove 22 effective is 1/4 of the maximum depth of the recess 21 or above.

### Examples

### Example 1

A 110 µm thick substrate 12 was prepared by bonding an 18 µm thick electrolytic copper foil to one surface of a 70 µm thick glass-epoxy substrate by a 20 µm thick adhesive layer, coating both the surfaces of the substrate with 1.9 µm thick Ni films by plating, coating the surfaces of both the Ni films with 0.1 µm Au films by plating, and forming a 15 µm high, 0.3 mm wide frame of a solder resist resin on an IC chip support surface. A 3.5 mm square, 250 µm thick IC chip 14 is bonded to the substrate 12 by an epoxy resin, and the IC chip 14 was connected electrically to terminals by wire bonding using wires 15. A resin solution containing 20% cresol novolac epoxy resin, 2% amine hardener, 77% spherical silica particles of 20 µm in particle size and 1% carbon black was printed in a resin solution tablet by screen printing using a 4 mm thick metal stencil so as to cover the IC chip 14 and the bonding wires 15. The spherical silica particles contained in the resin solution are the solid component, and the rest is the resin component Then, the resin solution tablet was heated at 150°C for 2 hr for hardening to form a sealing resin covering 16. Thus, a 600 µm thick IC module 11 was formed. The sealing resin covering had an elastic modulus of 1560 kgf/mm² and a bending strength of 16 kgf/mm².

It was found through the observation of the surface of the sealing resin covering 16 that any solid component is not contained in the surface of the sealing resin covering 16 and the surface of the sealing resin covering 16 is formed only of the resin component.

A recess 21 of 620 µm in depth, a support surface 18 at a depth of 110 µm and an outer groove 23 of 450 µm in depth were formed by a spot facing in a surface of a card base 20 formed by punching a PVC sheet. The IC module 11 was placed in the recess 21 of the base card 20 and was bonded to the base card 20 by cyanoacrylate (SHIKOMETTO 77 commercially available from HENKERU), i.e., an adhesive, to hold the IC module 11 fixedly in the recess 21. Thus, an IC card 10 was completed.

The IC card 10 was placed on a steel plate, and the IC card 10 was subjected to a point pressure withstand strength test, in which a 11 mm diameter steel ball placed on a central part of the IC module 11 was lowered at a rate of 1 mm/min and the operation of the IC module 11 was evaluated. The IC module did not malfunction until the load on the IC card 10 reached 18 kgf.

### Example 2

An IC card 10 in Example 2 was fabricated by the foregoing processes and by using the same components as those of the IC card in Example 1. A space formed between the sealing resin covering 16 of the IC module 11 and the bottom surface of the recess 21 of the base card 20 was filled up with the adhesive used in fabricating the IC card 10 in Example 1. The IC card was subjected to the same point pressure withstand strength test. The IC module 11 functioned normally even under a load of 20 kgf.

### Example 3

An IC card 10 in Example 3 was provided with a base card 20 with a recess 21 of the same shape as a sealing resin covering 16. The base card 20 was provided in its recess with a stress relaxing groove 22 of 0.5 mm in width and 500 µm in depth. Test pieces of 30 mm sq. each provided in its central part with an IC module included in the IC card were prepared. The test pieces were subjected to a convex bending test and a concave bending test, in which the long sides and the short sides of the test pieces were bent 100 times for convex and concave bending (50 times in opposite directions) by a deflection of 8.7 mm at a deflecting rate of 30 mm/min. Although peripheral parts of the IC cards 10 cracked when the IC cards were bent for convex and concave bending, the IC chips 14 functioned properly.

### Comparative Examples

### Comparative example 1

An IC module was fabricated in a thickness of 700 µm by the same method as that by which the IC card in Example 1 was fabricated, and a sealing resin covering 16 included in the IC module was ground to finish the IC module 11 in a thickness of 600 µm and the surface of the sealing resin covering 16 was observed. Both the resin component and the solid component appeared in the surface of the sealing resin covering 16, and an area occupied by the solid component was greater than that occupied by the resin component.

An IC card 10 was formed by mounting the IC module 11 on a base card 20, and the IC card 10 was subjected to a point pressure withstand strength test. The IC module malfunctioned when point pressure was increased to 7 kgf.

### Comparative example 2

An IC module 11 was made by forming a sealing resin covering 16 by transfer molding on the same substrate 12 as that employed in Example 1. An IC card 10 was fabricated by mounting the IC module 11 on a base card 20, and the IC card 10 was subjected to a point pressure withstand strength test. The IC module malfunctioned when point pressure was increased to 5 kgf.

As is apparent from the foregoing description, according to the present invention, the amount of the solid component, which causes cracking, in a surface layer of the sealing resin covering covering the IC chip and the connecting members can be reduced. Accordingly, the sealing resin covering of the IC module neither cracks nor breaks even if external pressure is applied to the IC card and point load is exerted on the surface of the sealing resin covering.

### Second Embodiment

An IC card in a second embodiment according to the present invention will be described hereinafter with reference to the accompanying drawings.

Fig. 11 is a sectional view of the IC card in the second embodiment. The IC card is provided with a contact IC module 101 provided with external terminals to be connected to the terminals of an external processing device. Terminals of the terminal member 111 are formed by patterning a conductive layer consisting of a 35 µm thick copper foil, a nickel film of 1.0 µm or above formed by plating on the copper foil, and a gold film of 0.3 µm or above in thickness formed by plating on the nickel film. A substrate 113 of, for example, 120 µm in thickness of an insulating material, such as a glass-epoxy sheet, provided with through holes for bonding wires is bonded to the back surfaces of the terminals of the terminal member 111 by an adhesive layer 112 of, for example 19 µm in thickness. An IC chip 114 of, for example, 250 µm in thickness is bonded to a central part of the substrate 113 by an adhesive layer 112 of, for example, 20 µm in thickness. Parts of the back surfaces of the terminals of the terminal member 111 exposed in the through holes of the substrate 113 are connected to the IC chip 114 by bonding wires 115. The IC chip 114 and the bonding wires 115 are sealed entirely in and protected by a sealing resin covering 116 containing an epoxy resin.

Fig. 12 is a sectional view of an IC card employing the foregoing IC module. The IC card has the IC module 101 and a base card 102 provided with a recess 103 for receiving the IC module 101 therein. The base card 102 is a four-layer laminated structure consisting of core sheets 121 and 122, and over sheets 123 and 124 bonded to the exposed surfaces of the core sheets 121 and 122, respectively. The recess 103 is formed in the base card 102 by machining or the like, and the IC module 101 is placed in the recess 103.

The core sheets 121 and 122 are, for example, about 330 µm in thickness, and the over sheets 123 and 124 are, for example, about 50 µm in thickness. These four sheets are laminated to construct the base card 102 of 760 µm in thickness meeting ISO Standard 7810. The core sheets 121 and 122 and the over sheets 123 and 124 may be, for example, glass-epoxy sheets, polyimide sheets, PVC (polyvinyl chloride) sheets or PET (polyethylene terephthalate) sheets. The laminated base card 102 is formed by laminating the core sheets 121 and 122 and the over sheets 123 and 124 by adhesive bonding using an adhesive or by fusion using a hot press.

A method of fabricating the foregoing IC module will be described hereinafter. For example, a 120 µm thick glass-epoxy, polyester, polyimide or bismaleimide-triazine resin film is used as the substrate 113 of the IC module. The surface of the substrate 113 may be roughened in a surface roughness (center line average roughness) of, for example, about 28000 Å to prevent the flow of the sealing resin.

Through holes for bonding wires are formed in the substrate 113 at desired positions, the terminal member 111 is bonded to the substrate 113 by hot pressing using an adhesive layer 112. A resist film is formed on the terminal member 111, and the terminal member 111 is subjected to a photolithographic etching process to pattern the terminal member 111 in the terminals. The surfaces of the terminals of the terminal member 111 are coated with a plated film. A sealing frame, not shown, for damming the sealing resin is formed by a 25 µm thick solder resist film on a surface of the substrate 113 opposite to that on which the terminal member 111 is formed. If the frame is excessively wide, the area of a part of the surface of the substrate 113 to be bonded to the base card is excessively small and the substrate 113 is bonded to the base card by an insufficient bonding strength. Therefore, it is preferable that the height of the frame is in the range of 5 to 15 µm. The IC chip 114 is bonded to the substrate 113, the IC chip 114 is connected electrically to the back surfaces of the terminals of the terminal member 111 by bonding wires 115 extended through the through holes.

Then, the IC chip 114 and the bonding wires 115 are covered with the sealing resin, which is in a liquid state at a normal temperature, containing the epoxy resin by a screen printing process or a potting process to seal the IC chip 114 and the bonding wires 115 in sealing resin tablet. The sealing resin has a viscosity in the range of 50 to 90 Pa·s at 25°C, more preferably, in the range of 50 to 70 Pa·s at 25°C, and a thixotropy index in the range of 1.2 to 1.6, more preferably, in the range of 1.2 to 1.4. Preferably, the sealing resin tablet as hardened has an elastic modulus of 1400 kgf/mm² or above and a bending strength of 11 kgf/mm² or above. Thixotropy index is the ratio of a viscosity of a substance stirred with a stirrer rotating at a specified rotating speed to a viscosity of the same stirred with the stirrer rotating at a rotating speed of ten times as much as the specified rotating speed. For example, thixotropy index is defined by the ratio of a viscosity when a substance is stirred at 5 rpm to a viscosity when the same substance is stirred at 50 rpm. Viscosity and thixotropy index can be measured by using, for example, the rotor No. 7 of a viscometer B8H. The sealing resin containing an epoxy resin can be prepared by, for example, adding 0.5% defoaming agent, i.e., a surface active agent, to a phenolic epoxy resin containing a modified amine hardener. A preferable thixotropy adjusting agent for adjusting viscosity and thixotropy index is fine silica powder or organic amide.

Bubbles remaining in the sealing resin tablet are removed by a defoaming process, and the sealing resin tablet is heated, for example, at 80°C for 12 min, at 120°C for 12 min and at 150°C for 120 min by a curing process to form the sealing resin covering by hardening the sealing resin tablet. If necessary, the thickness of the sealing resin tablet is adjusted by grinding. A plurality of such IC modules are formed on the substrate, and the substrate is cut by a punch press into individual IC modules of a predetermined size.

The sealing resin for forming the IC module has an appropriate viscosity and does not run out of a predetermined place when sealing the IC chip in the sealing resin. The possibility of inducing the breakage of the IC chip by a force exerted on the sealing resin covering can be reduced by forming the sealing resin covering so that any bubbles may not remain in the hardened sealing resin covering.

### Example

An example of an IC module in accordance with the present invention will be described below.

A 35 µm thick copper foil for forming a terminal member was bonded by a 19 µm adhesive layer to a surface of a 160 µm thick glass-epoxy substrate (FR4 mat) of about 28000 Å in surface roughness (center line average roughness). A nickel film of 1.0 µm or above was formed by plating on the copper foil, and a gold film of 0.3 µm or above in thickness was formed by plating on the nickel film. A sealing frame of a 5 µm thick solder resist film was formed on a surface of the substrate opposite to the surface on which the terminal member is formed. The sealing frame is an inexpensive ordinary dam. An IC chip of about 250 µm in thickness was bonded by an adhesive layer to a central part of the substrate, and then the terminal member was connected to the IC chip by bonding wires.

The IC chip and the bonding wires were covered with a sealing resin prepared by adding 0.5% defoaming agent, i.e., a surface active agent, to a phenolic epoxy resin containing a modified amine hardener, and printed in a sealing resin tablet by a screen printing process at a room temperature. Fine silica powder or organic amide was used as a thixotropy adjusting agent for adjusting viscosity and thixotropy index.

The sealing resin tablet was defoamed by a defoaming process. The sealing resin tablet was heated at 80°C for 12 min, at 120°C for 12 min and at 150°C for 120 min by a curing process to form a sealing resin covering by hardening the sealing resin tablet. A plurality of such IC modules thus formed on the substrate were cut by a punch press into individual contact IC modules of a predetermined size.

The viscosities and thixotropy indices of the sealing resins having different values of silica powder content and containing different thixotropy adjusting agents in different values of thixotropy adjusting agent content, and forming the sealing resin coverings of the thus fabricated IC modules are tabulated in Table 1. In Table 1, the thixotropy index is the ratio of a viscosity when the sealing resin is stirred at 5 rpm to a viscosity when the same sealing resin is stirred at 50 rpm.

The amount of bubbles contained in the sealing resin and modes of flow of the sealing resin after printing and curing were observed. The amount of bubbles contained in the sealing resin was evaluated according to the three-grade system ( ○ : None, △ : Practically permissible amount, X : Practically impermissible amount). The flow of the sealing resin was evaluated according to the two-grade system ( ○ : Satisfactory, X: Unsatisfactory).

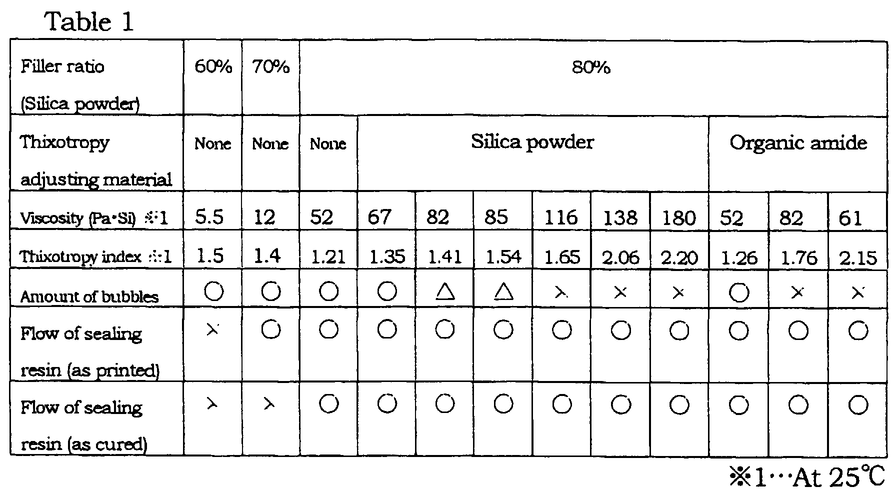

It is known from Table 1 that the run of the sealing resin out of a predetermined place can be suppressed and trapping of bubbles in the sealing resin can be prevented by properly controlling the viscosity and the thixotropy index of the sealing resin.

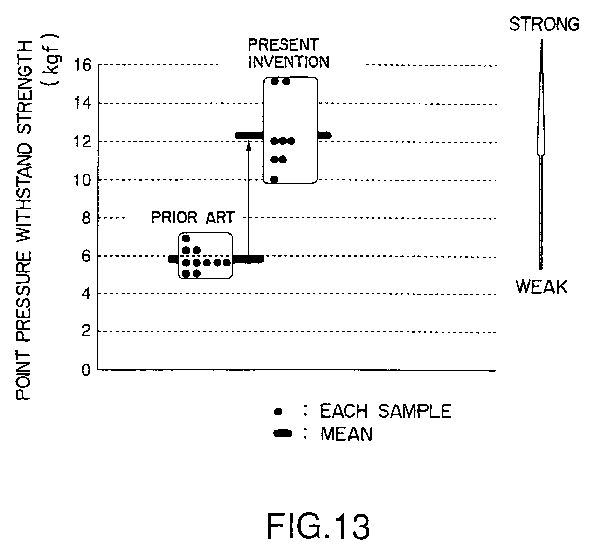

As shown in Fig. 13, the mean point pressure withstand strength of IC cards employing the IC modules of the present invention is as high as 12 kgf, whereas the mean point pressure withstand strength of conventional IC cards is only 6 kgf, which proved that the present invention is effective in preventing the breakage of IC chips.

The present invention is not limited in its practical application to the foregoing specific embodiments. For example, the IC card may be of either a contact type or a noncontact type, and hence the IC module may be of either a contact type or a noncontact type. The material and the height of the dam, the quality and the surface roughness of the IC module substrate, the resin-sealing method, the resin curing conditions are not limited to those described herein in connection with the preferred embodiments and changes and variations may be made therein without departing from the scope of the present invention.

As is apparent from the foregoing description, the present invention provides the sealing resin not running out of the predetermined place when sealing the IC chip with the sealing resin, not trapping bubbles therein and capable of reducing the possibility of inducing the breakage of the IC chip when an external force is exerted thereon, the IC module, the IC card and the IC card fabricating method.

## Claims

1. An IC module comprising:
a substrate;
a terminal member;
an IC chip;
connecting members connecting the terminal member to the IC chip; and
a sealing resin covering for covering the IC chip and the connecting members;
wherein the sealing resin covering is formed of a sealing resin containing a resin component and a solid component, the weight ratio of the resin component to the solid component in a near-surface layer of the sealing resin covering is in the range of 90:10 to 100:0, and a surface layer of the sealing resin covering consists of the resin component and the solid component occupying an area smaller than that occupied by the resin component.

2. The IC module according to claim 1, wherein
the resin component contained in the sealing resin covering has an elastic modulus of 1400 kgf/mm² or above and a bending strength of 11 kgf/mm² or above.

3. The IC module according to claim 1, wherein
the weight ratio of the resin component to the solid component in the near-surface layer of the sealing resin covering is 100:0, and the surface layer of the sealing resin covering contains only the resin component.

4. The IC module according to claim 1, wherein
a frame is formed on the substrate so as to surround the sealing resin covering.

5. The IC module according to claim 1, wherein
the ratio of the height of the frame to the height of the sealing resin covering is in the range of 0.98% to 3.19%.

6. The IC module according to claim 1, wherein the sum of thicknesses of the substrate and the terminal member is 130 µm or below.

7. An IC module comprising:
a substrate;
an IC chip; and
a sealing resin covering for covering the IC chip;
wherein the sealing resin covering is formed by hardening a sealing resin containing an epoxy resin, and having a viscosity in the range of 50 to 90 Pa·s at 25°C and a thixotropy index in the range of 1.2 to 1.6.

8. The IC module according to claim 7, wherein
the sealing resin has a viscosity in the range of 50 to 70 Pa·s at 25°C and a thixotropy index in the range of 1.2 to 1.4.

9. The IC module according to claim 7, wherein
the sealing resin as hardened has an elastic modulus of 1400 kgf/mm² or above and a bending strength of 11 kgf/mm² or above.

10. An IC card comprising:
an IC module comprising:
a substrate,
a terminal member;
an IC chip,
connecting members connecting the terminal member to the IC chip, and
a sealing resin covering for covering the IC chip and the connecting members,
the sealing resin covering being formed of a sealing resin containing a resin component and a solid component, the weight ratio of the resin component to the solid component in a near-surface layer of the sealing resin covering being in the range of 90:10 to 100:0, and a surface layer of the sealing resin covering consisting of the resin component and the solid component occupying an area smaller than that occupied by the resin component; and
a base card provided with a recess for receiving the IC module therein.

11. The IC card according to claim 10, wherein
at least a part of the sealing resin covering is in contact with the base card through a packing material.

12. The IC card according to claim 11, wherein
the packing material is an adhesive containing a cyanoacrylate resin as a principal component capable of bonding the sealing resin covering of the IC module and the base card.

13. The IC card according to claim 10, wherein
the recess of the card base has a sectional shape substantially corresponding to a sectional shape of the sealing resin covering.

14. The IC card according to claim 13, wherein
the sectional shape of the recess of the base cad has a plurality of steps, the depth of each step of the recess is greater than that of the next step nearer to the peripheral part of the recess.

15. The IC card according to claim 14, wherein
the difference in depth between the step of the recess of the base card adjacent to the periphery of the recess and the step of the same adjacent to the central part of the recess is 100 µm or above.

16. The IC card according to claim 10, wherein a groove is formed in the base card so as to surround the recess.

17. The IC card according to claim 16, wherein the depth of the groove is 1/4 or above of the depth of the central part of the recess.

18. An IC card comprising:
an IC module comprising: a substrate, an IC chip, and a sealing resin covering for covering the IC chip; and
a base card provided with a recess for receiving the IC module therein;
wherein the sealing resin covering is formed by hardening a sealing resin containing an epoxy resin, and having a viscosity in the range of 50 to 90 Pa·s at 25°C and a thixotropy index in the range of 1.2 to 1.6.

19. The IC card according to claim 18, wherein
the sealing resin has a viscosity in the range of 50 to 70 Pa·s at 25°C and a thixotropy index in the range of 1.2 to 1.4.

20. The IC card according to claim 18, wherein
the sealing resin as hardened has an elastic modulus of 1400 kgf/mm² or above and a bending strength of 11 kgf/mm² or above.

21. An IC module fabricating method comprising the steps of:
preparing a substrate;
forming a terminal member;
mounting an IC chip on the substrate;
connecting the terminal member to the IC chip by connecting members;
making the IC chip face upwardly and covering the IC chip and the connecting members with a resin solution containing a resin component and a solid component; and
forming a sealing resin covering by hardening the resin solution so that the weight ratio of the resin component to the solid component in the near-surface layer of the sealing resin covering is in the range of 90:10 to 100:0, and a surface layer of the sealing resin covering consists of the resin component and the solid component occupying an area smaller than that occupied by the resin component.

22. An IC module fabricating method comprising the steps of:
preparing a substrate;
forming a terminal member;
mounting an IC chip on the substrate;
electrically connecting the terminal member to the IC chip;
covering the IC chip with a sealing resin containing an epoxy resin and having a viscosity in the range of 50 to 90 Pa·s at 25°C and a thixotropy index in the range of 1.2 to 1.6 before hardening; and
hardening the sealing resin.

23. The IC module fabricating method according to claim 22, wherein
the sealing resin has a viscosity in the range of 50 to 70 Pa·s and a thixotropy index in the range of 1.2 to 1.4.

24. The IC module fabricating method according to claim 22, wherein
the sealing resin has an elastic modulus of 1400 kgf/mm² or above and a bending strength of 11 kgf/mm² or above after hardening.

25. A sealing resin for sealing an IC chip mounted on a substrate to form an IC module, having a viscosity in the range of 50 to 90 Pa·s at 25°C and a thixotropy index in the range of 1.2 to 1.6 before hardening.

26. The sealing resin according to claim 25, wherein
the viscosity is in the range of 50 to 70 Pa·s and the thixotropy index is in the range of 1.2 to 1.4.

27. The sealing resin according to claim 25, wherein
the elastic modulus of the sealing resin is 1400 kgf/mm² or above and the bending strength of the sealing resin is 11 kgf/mm² or above.
